# EUROPEAN PATENT SPECIFICATION

(11) **EP 4 083 845 B1**
(45) Date of publication and mention of the grant of the patent: **16.10.2024**
(21) Application number: 21762322.2
(22) Date of filing: 11.08.2021
(51) Int. Cl.: B61L 27/53, B61L 5/06, G06Q 10/20

(54) **TURNOUT FAULT DIAGNOSIS METHOD AND APPARATUS**
VERFAHREN ZUR DIAGNOSE VON WEICHENFEHLERN, GERÄT ZUR DIAGNOSE VON WEICHENFEHLERN
PROCÉDÉ ET APPAREIL DE DIAGNOSTIC DE DÉFAUT DE BRANCHEMENT

(30) Priority: 05.03.2021 CN 202110247148
(43) Date of publication of application: 02.11.2022
(73) Proprietor: CRSC Research & Design Institute Group Co., Ltd., Beijing 100070 (CN)
(72) Inventor: LUO, Yuanhui, Beijing 100070 (CN); XIAO, Qian, Beijing 100070 (CN); ZHAI, Anan, Beijing 100070 (CN); WANG, Tengfei, Beijing 100070 (CN)
(74) Representative: Haseltine Lake Kempner LLP
(86) International application number: PCT/CN2021/111953
(87) International publication number: WO 2022/183684

(56) References cited:
- EP-A1- 3 702 238
- CN-A- 102 381 340
- CN-A- 105 260 595
- CN-A- 108 287 273
- CN-A- 108 416 362
- CN-A- 109 677 448
- CN-A- 112 036 505
- CN-A- 112 214 634
- CN-A- 112 906 230
- OU DONGXIU ET AL: "Hybrid fault diagnosis of railway switches based on the segmentation of monitoring curves", EKSPLOATACJA I NIEZAWODNOSC - MAINTENANCE AND RELIABILITY, vol. 20, no. 4, 18 September 2018 (2018-09-18), pages 514 - 522, XP055975733, ISSN: 1507-2711, Retrieved from the Internet <URL:https://pdfs.semanticscholar.org/0093/dfcdd02de661c93fa0916f591207f9f03edf.pdf> [retrieved on 20221028], DOI: 10.17531/ein.2018.4.2

## Description

### TECHNICAL FIELD

Embodiments of the present disclosure relate to the technical field of railway transportation, and in particular, to a turnout fault diagnosing method, a turnout fault diagnosing apparatus, an electronic device and a computer-readable storage medium.

### BACKGROUND

A turnout switching device is one of the three outdoor parts of a railway signal device, and if the turnout switching device has a fault, traffic will be severely affected. Since a turnout rotates very frequently in railway operation and a fault rate is relatively high, inspection and maintenance of the turnout is very important.

A related technology is to establish a fault standard curve library of the turnout, and to compare turnout action curves with the fault standard curve library in real time sequentially to give out the fault content of the turnout. However, establishment of the fault standard curve library needs to be supported by massive actual fault curve data, the standard curve library is difficult to establish, and judgment of a turnout fault depends on the number of standard fault curves of fault curves in the curve library, which has very low applicability; and in a case of different shapes of turnout action curves in engineering application, accuracy of fault diagnosis will be seriously reduced.

Some prior arts can be seen in CN 112214634A and CN 108287273B.

### SUMMARY

Embodiments of the present disclosure provides a turnout fault diagnosing method, a turnout fault diagnosing apparatus, an electronic device and a computer-readable storage medium so as to accurately locate start and end positions of each turnout action, to solve the problem that the accuracy of turnout fault diagnosis is reduced due to the different shapes of the turnout action curves.

The invention is set out in the appended set of claims.

By using the technical solution of the present application, start and end points of each turnout action phase in the turnout action curve can be determined according to the value of each discrete sequence item in the turnout action curve, so as to implement accurate location of an action curve that is experienced by each turnout action phase, and on such basis, directional diagnosis can be performed on action curve segments that are experienced by each turnout action phase respectively, to avoid that targeted fault diagnosis cannot be performed due to the fact that time lengths of a same turnout action phase in different turnout action curves are inconsistent and there are many types of turnout action phases, thereby solving the problem that the accuracy of turnout fault diagnosis is reduced due to different shapes of the turnout action curves, and the technical effect that the position of a turnout fault is located more accurately, which helps a device maintainer to quickly handle the fault, to reduce the influence time on the railway operation can be achieved.

In order to understand the technical means of the present invention more clearly, it can be implemented according to the contents of the specification, and in order to make the above and other objects, features and advantages of the present invention more understandable, the specific embodiments are listed below.

### BRIEF DESCRIPTION OF THE DRAWINGS

By reading the detailed description of the non-limiting embodiments with reference to the following drawings, the other features, objects and advantages of the present disclosure will become more apparent. The drawings are only used for illustrating the preferred embodiments, and shall not be considered as a limitation to the present disclosure. Also, throughout the drawings, the same reference signs are used to denote the same components. In the drawings:
FIG. 1 is a flowchart of a turnout fault diagnosing method according to embodiment one of the present application;
FIG. 2 is a flowchart of another turnout fault diagnosing method provided by embodiment two of the present application;
FIG. 3 is a chart of a turnout action power curve provided by an embodiment of the present application;
FIG. 4 is a schematic diagram of a value range of a target discrete sequence item provided by an embodiment of the present application;
FIG. 5 is a structural schematic diagram of a turnout fault diagnosing apparatus provided by embodiment three of the present application; and
FIG. 6 is a structural schematic diagram of an electronic device provided by embodiment four of the present application.

### DETAILED DESCRIPTION

The present invention will be further described in detail below with reference to the drawings and embodiments. It can be understood that the specific embodiments described here are only used to illustrate rather than limit the present invention. In addition, it should further be noted that, for ease of description, the drawings only show a part of the structure related to the present invention, but not all of the structure.

Before further discussion of the exemplary embodiments, it should be noted that some exemplary embodiments are described as processes or methods depicted as flowcharts. Although the flowcharts describe the operations (or steps) as sequential processing, many of the operations can be implemented in parallel, concurrently, or simultaneously. In addition, the order of various operations can be rearranged. The processing may be terminated when its operation is completed, but may also have additional steps not included in the drawings. The processing may correspond to methods, functions, procedures, subroutines, subprograms, and so on.

### Embodiment one

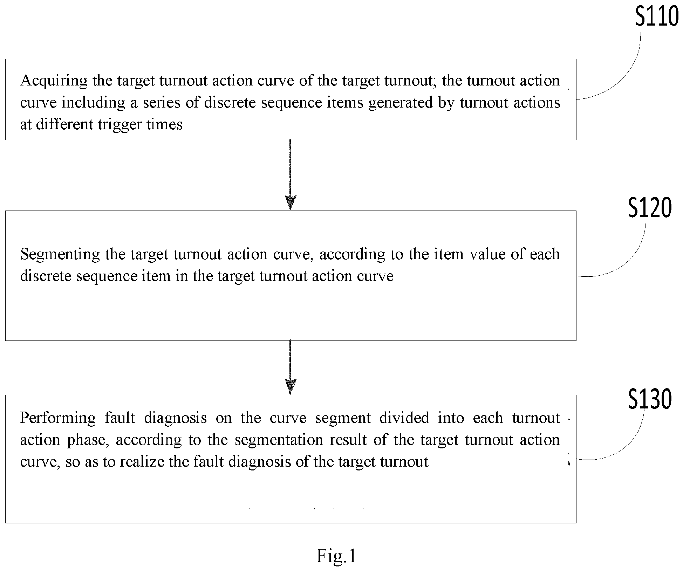

FIG. 1 is a flowchart of a turnout fault diagnosing method provided by embodiment one of the present invention. The method can be applied to a case where fault diagnosis is performed when a railway track turnout is switched, the method can be executed by a turnout fault diagnosing apparatus, and the apparatus can be implemented by software and/or hardware, and can be integrated into an electronic device having a network communication function. As shown in FIG. 1, the turnout fault diagnosing method in this embodiment includes steps of:
S 110: a target turnout action curve of a target turnout is acquired; the turnout action curve includes a series of discrete sequence items generated turnout actions at different trigger times.

Wherein a turnout fault diagnosis system acquires the target turnout action curve of the target turnout, in the process of using a turnout switching device to execute turnout rotation, corresponding discrete sequence items will be generated at different rotation trigger times, and these discrete sequence items are connected to form a turnout action curve when the turnout rotation is executed. One turnout action curve can include four turnout action phases of turnout unlocking, turnout rotation, turnout locking, and switch termination. The turnout action curve can be a turnout action power curve or a turnout action current curve that is generated by executing the turnout actions, the type of a discrete sequence item can be power or current, and the value of the discrete sequence item can be a power value or a current value. The turnout action curve includes a series of discrete sequence items generated by the turnout actions at different trigger times.

In an optional solution of this embodiment, it can be combined with one or more optional solutions in this embodiment. Wherein the type of a discrete sequence item may be power or current. The current curve or power curve can be acquired as required or according to actual turnout actions.

S 120: the target turnout action curve is segmented, according to the value of each discrete sequence item in the target turnout action curve.

Wherein the turnout fault diagnosis system segments the target turnout action curve according to the value of each discrete sequence item in the target turnout action curve. All discrete sequence items can be divided into turnout action phases to which they belong according to the value of each discrete sequence item, and thus, the turnout action curve can be segmented into four turnout action phases of turnout unlocking, turnout rotation, turnout locking, and switch termination, and each turnout action phase will have multiple turnout action curve segments that consist of the discrete sequence items.

In an optional solution of this embodiment, it can be combined with one or more optional solutions in this embodiment. Wherein segmenting the target turnout action curve according to the value of each discrete sequence item in the target turnout action curve may include operations of:
Taking the discrete sequence item with the maximum value in the discrete sequence items in the turnout action curve as a start point of the turnout unlocking phase in the target turnout action curve.

Wherein turnout fault diagnosis takes the discrete sequence item with the maximum value in the discrete sequence items of the turnout action curve as the start point of the turnout unlocking phase in the target turnout action curve, that is, a first sequence item of the discrete sequence items in the turnout unlocking phase of the four turnout action phases in the turnout action curve. Taking that a turnout curve discrete time sequence is A={A1,A2,...,An}, and a discrete value sequence is B={B1,B2,...,Bn} as an example, a maximum value sequence item is Bx, then the start point of the turnout unlocking phase in the target turnout action curve is (Ax, Bx).

In an optional solution of this embodiment, it can be combined with one or more optional solutions in this embodiment. Wherein segmenting the target turnout action curve according to the value of each discrete sequence item in the target turnout action curve may further include operations of:
Taking a last discrete sequence item whose value is non-zero in the target turnout action curve as a start point of the rotation termination phase in the target turnout action curve, and taking the last discrete sequence item in the target turnout action curve as an end point of the rotation termination phase in the target turnout action curve, when it is determined that there is a discrete sequence item that its value is zero in the target turnout action curve.

Wherein the last discrete sequence item whose value is non-zero in the target turnout action curve is taken as the start point of the rotation termination phase in the target turnout action curve, and the last discrete sequence item in the target turnout action curve is taken as an end point of the rotation termination phase in the target turnout action curve, when it is determined that there is a discrete sequence item whose value is zero in the target turnout action curve. According to the above optional solutions, the end point of the rotation termination phase in the target turnout action curve is (An, Bn), sorting is performed in time sequence, and as the start point of the rotation termination phase, the last discrete sequence item that its value is non-zero is (Ah, Bh).

S130: fault diagnosis is performed on curve segments divided into each turnout action phase, according to the segmentation result of the target turnout action curve, so as to implement the fault diagnosis of the target turnout.

Wherein the turnout fault diagnosis system performs fault diagnosis for curve segments of each phase, according to the segmentation result of the target turnout action curve, so as to implement the fault diagnosis of the target turnout.

Wherein, performing the fault diagnosis on the curve segments divided into each turnout action phase, according to the segmentation result of the target turnout action curve, so as to implement the fault diagnosis of the target turnout, includes the steps of:
Judging that the target turnout has a turnout locking fault, at the turnout unlocking phase and the turnout switch phase, if the values of discrete sequence items in the curve segments at the turnout unlocking phase and turnout switch phase in the target turnout action curve are continuously greater than a turnout unlocking threshold value for a preset time period;
Judging that the target turnout has a turnout idling fault, at the turnout switch phase, if the values of the discrete sequence items in the curve segments at the turnout switch phase in the target turnout action curve are continuously less than a turnout idling threshold value for a preset time period; the type of a discrete sequence item in the target turnout action curve being power, and the value of the discrete sequence item belonging to a power value;
Judging that the target turnout has a turnout jam fault, at the turnout switch phase, if the values of the discrete sequence items in the curve segments at the turnout switch phase in the target turnout action curve are continuously greater than a turnout jam threshold value for a preset time period.

Judging that the target turnout has a turnout unlocking fault, at the turnout locking phase, if the values of the discrete sequence items in the curve segments at the turnout locking phase in the target turnout action curve are all greater than zero,.

According to the technical solution of this embodiment, it acquires the target turnout action curve of the target turnout, then segments the target turnout action curve according to the value of each discrete sequence item in the target turnout action curve, and finally performs fault diagnosis on the curve segments divided into each turnout action phase, according to the segmentation result of the turnout action curve, so as to implement the fault diagnosis of the target turnout, such that a turnout fault is located more accurately, which helps the device maintainer to quickly handle the fault, to reduce the influence time on the railway operation, which has very high practicability.

### Embodiment two

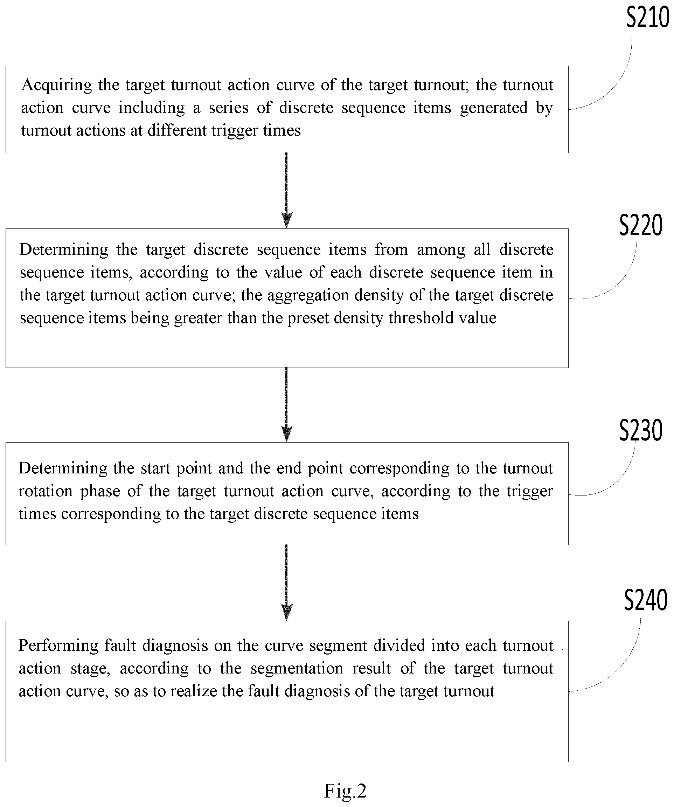

FIG. 2 is a flowchart of another turnout fault diagnosing method provided by embodiment two of the present application. The embodiment of the present invention further optimizes the foregoing embodiment on the basis of the above embodiment, and the embodiment of the present invention may be combined with each optional solution in the above one or more embodiments. As shown in FIG. 2, the turnout fault diagnosing method provided by the embodiment of the present invention may include steps of:

S210: a target turnout action curve of the target turnout is acquired; the turnout action curve including a series of discrete sequence items generated by the turnout actions at different trigger times.

S220: target discrete sequence items are determined from all discrete sequence items according to the value of each discrete sequence item in the target turnout action curve; the aggregation density of the target discrete sequence items is greater than a preset density threshold value.

Wherein the turnout fault diagnosis system determines target high-density discrete sequence items from all discrete sequence items according to the value of each discrete sequence item in the target turnout action curve, and the aggregation density of the target high-density discrete sequence items is greater than the preset density threshold value.

In an optional solution of this embodiment, it can be combined with one or more optional solutions in this embodiment. Wherein, determining the target discrete sequence items that its aggregation density is greater than the preset density threshold value from all discrete sequence items, according to the value of each discrete sequence item in the target turnout action curve, may include steps A1-A3:
Step A1: other discrete sequence items that the value difference between them and the discrete sequence item is within the preset difference range are determined, for each discrete sequence item in the target turnout action curve, from each discrete sequence item in the target turnout action curve.
Step A2: the ratio of the number of other discrete sequence items to the total number of the discrete sequence items of the target turnout action curve is taken as the aggregation density of the discrete sequence items.
Step A3: the discrete sequence items that its aggregation density is greater than the preset density threshold of all discrete sequence items of the target turnout action curve is taken as the target discrete sequence items.

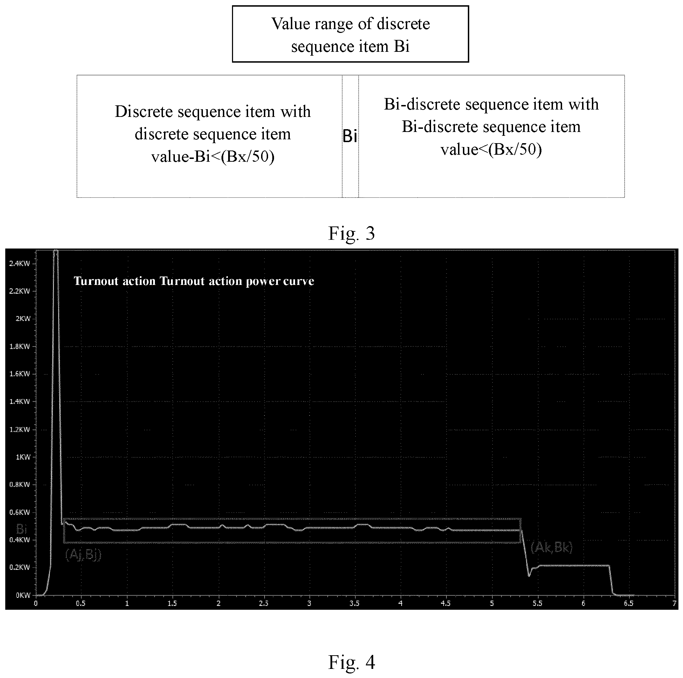

Exemplarily, determining the target discrete sequence items that its aggregation density is greater than the preset density threshold value from all the discrete sequence items can make each discrete sequence item regarded as a value range center, and any discrete sequence item can be expressed as Bi, then it can be that each discrete sequence item Bi is taken as the value range center, and Bx (the value of the maximum value sequence item)/50 is taken as a value range radius, the discrete sequence items contained in a value range can form a point set Bi, that is, the value difference between the value of the discrete sequence item Bi and the value of each discrete sequence item is calculated, and the discrete sequence items whose value difference is less than the value range radius of Bi are made to compose a point set (cluster) of Bi. The ratio of the number of the discrete sequence items falling in the point set Bi to the total number of discrete value points is calculated to obtain the density value Pi of the discrete sequence item B1, and a point that its density value is greater than a preset density threshold value is regarded as a high-density point, that is, the target discrete sequence items, where the preset density threshold value can be 0.5 or 0.6. As shown in FIG. 3, by taking the value of each discrete sequence item as a value range center, the target discrete sequence item is found out by judging the number of all discrete sequence items falling in the value range.

S230: the start point and the end point corresponding to the turnout rotation phase in the target turnout action curve are determined, according to the trigger times corresponding to the target discrete sequence items.

Wherein the start point and the end point corresponding to the turnout rotation phase in the target turnout action curve are determined, according to the trigger times corresponding to the target discrete sequence items.

In an optional solution of this embodiment, it can be combined with one or more optional solutions in this embodiment. Wherein determining the start point and the end point corresponding to the turnout rotation phase in the target turnout action curve, according to the trigger times corresponding to the target discrete sequence items, may includes steps B1-B2:
Step B1: adjacent target discrete sequence items are sorted, according to the sequence of the trigger times corresponding to the target discrete sequence items.
Step B2: a first target discrete sequence and a last target discrete sequence item from a sorting result are correspondingly taken as the start point and the end point of the turnout rotation phase in the target turnout action curve, respectively.

Wherein the target discrete sequence items can be sorted in time domain according to the time discrete sequence, and forward-most and rearward-most target discrete sequence items of the target discrete sequence in time domain are taken as the start and end points of the turnout switch phase, respectively. As shown in FIG. 4, according to the above optional solutions, the target discrete sequence items are sorted in time domain according to the time discrete sequence, a forward-most point is (Aj, Bj), and a rearward-most point is (Ak, Bk). Finally, through the above optional solutions, it can be concluded that the turnout unlocking phase is a curve from (Ax, Bx) to (Aj, Bj), the turnout switch phase is a curve from (Aj, Bj) to (Ak, Bk), and the turnout locking phase is a curve from (Ak, Bk) to (Ah, Bh), and the switch termination phase is a curve from (Ah, Bh) to (An, Bn).

S240: fault diagnosis is performed on the curve segment divided into each turnout action phase, according to the segmentation result of the target turnout action curve, so as to implement the fault diagnosis of the target turnout.

According to the technical solution of this embodiment, it acquires the target turnout action curve of the target turnout, and then determines the target discrete sequence items from all discrete sequence items according to the value of each discrete sequence item in the target turnout action curve; the aggregation density of the target discrete sequence items is greater than the preset density threshold value, and then the start point and the end point corresponding to the turnout rotation phase of the target turnout action curve are determined according to the trigger times corresponding to the target discrete sequence items, and finally, fault diagnosis is performed on the curve segments divided into each turnout action phase, according to the segmentation result of the turnout action curve, thus achieving that a curve of the turnout switch phase is determined by calculating the distribution density of discrete sequence items, so as to implement the fault diagnosis of each phase of the target turnout, such that the position of the turnout fault is located more accurately, which helps the device maintainer to quickly handle the fault, which has higher applicability, and solves the problem that the accuracy of fault diagnosis is reduced due to the different shapes of the turnout curves in engineering application.

### Embodiment three

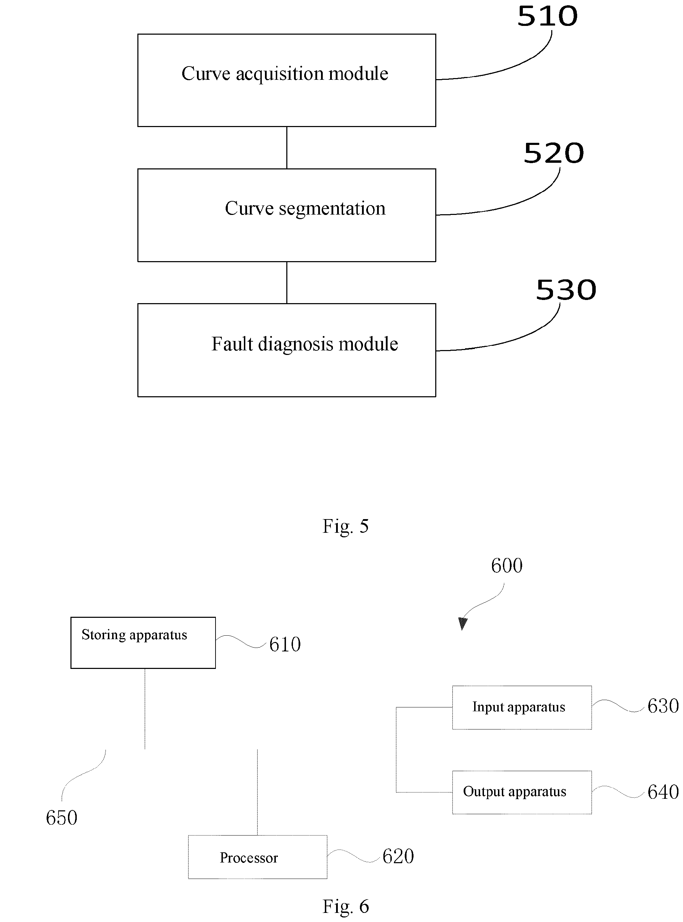

FIG. 5 is a structural schematic diagram of a turnout fault diagnosing apparatus provided by embodiment three of the present disclose. The apparatus can be applied to a case that fault diagnosis is performed when the railway track turnout is switched, and the apparatus can be implementd by software and/or hardware, and is integrated in an electronic device. The apparatus is used to implement the turnout fault diagnosing method provided by the foregoing embodiment. As shown in FIG. 5, the turnout fault diagnosing apparatus provided in this embodiment includes:
A curve acquisition module 510, configured to acquire a target turnout action curve of a target turnout; the turnout action curve including a series of discrete sequence items generated by turnout actions at different trigger times;
A curve segmentation module 520, configured to segment the target turnout action curve, according to the value of each discrete sequence item in the target turnout action curve; and
A fault diagnosis module 530, configured to perform fault diagnosis on curve segments divided into each turnout action phase, according to a segmentation result of the target turnout action curve, so as to implement the fault diagnosis of the target turnout.

On the basis of the above embodiment, optionally, the type of the discrete sequence item being power or current.

On the basis of the above embodiment, optionally, the curve segmentation module 520 is configured to:
Take the discrete sequence item with the maximum value in the discrete sequence items in the turnout action curve as the start point of the turnout unlocking phase in the target turnout action curve.

On the basis of the above embodiment, optionally, the curve segmentation module 520 is further configured to:
Take the last discrete sequence item whose value is non-zero in the target turnout action curve as the start point of the rotation termination phase in the target turnout action curve, and taking the last discrete sequence item in the target turnout action curve as the end point of the rotation termination phase in the target turnout action curve, when it is determined that there is a discrete sequence item that its value is zero in the target turnout action curve.

On the basis of the above embodiment, optionally, the curve segmentation module 520 is further configured to:
Determine the target discrete sequence items from all discrete sequence items, according to the value of each discrete sequence item in the target turnout action curve; the aggregation density of the target discrete sequence items being greater than a preset density threshold value;
Determine the start point and the end point corresponding to the turnout rotation phase in the target turnout action curve, according to the trigger times corresponding to the target discrete sequence items.

On the basis of the above embodiment, optionally, the curve segmentation module 520 is further configured to:
Determine the target discrete sequence items that its aggregation density is greater than a preset density threshold value from each discrete sequence item, according to the value of each discrete sequence item in the target turnout action curve, includes:
Determine other discrete sequence items that the value difference between them and the discrete sequence item is within a preset difference range, for each discrete sequence item in the target turnout action curve, from each discrete sequence item of the target turnout action curve;
Take the ratio of the number of other discrete sequence items to the total number of the discrete sequence items of the target turnout action curve as the aggregation density of the discrete sequence items; and
Take the discrete sequence items that its aggregation density is greater than a preset density threshold value in all discrete series items in the target turnout action curve as the target discrete sequence items.

On the basis of the above embodiment, optionally, the curve segmentation module 520 is further configured to:
Determine the start point and the end point corresponding to the turnout rotation phase of the target turnout action curve, according to the trigger times corresponding to the target discrete sequence items, includes:
Sort adjacent target discrete sequence items according to the sequence of the trigger times corresponding to the target discrete sequence items;
Take the first target discrete sequence and the last target discrete sequence item from the sorting result correspondingly as the start point and the end point of the turnout rotation phase in the target turnout action curve, respectively.

On the basis of the above embodiment, the fault diagnosis module 530 is configured to:
Judge that the target turnout has a turnout locking fault, at the turnout unlocking phase and the turnout switch phase, if the values of the discrete sequence items in the curve segments at the turnout unlocking phase and the turnout switch phase in the target turnout action curve are continuously greater than a turnout unlocking threshold value for a preset period of time;
Determine that the target turnout has a turnout idling fault, at the turnout switch phase, if the values of the discrete sequence items in the curve segments at the turnout switch phase in the target turnout action curve are continuously less than a turnout idling threshold value for a preset time; the type of the discrete sequence item in the target turnout action curve being power, and the value of the discrete sequence item belonging to the power value; and
Determine that the target turnout has a turnout jam fault, at the turnout switch phase, if the values of the discrete sequence items in the curve segments at the turnout switch phase in the target turnout action curve are continuously greater than a turnout jam threshold value for a preset period of time.

The turnout fault diagnosing apparatus provided by the embodiment of the present invention can execute the turnout fault diagnosing method provided by any embodiment of the present invention, and has corresponding functions and beneficial effects of executing the turnout fault diagnosing method. For the detailed process, refer to the related operations of the turnout fault diagnosing method in the foregoing embodiment.

### Embodiment four

FIG. 6 is a structural schematic diagram of an electronic device provided by embodiment four of the present application. The embodiment of the present application provides an electronic device, in which the turnout fault diagnosing apparatus provided by the embodiment of the present application can be integrated. As shown in FIG. 6, this embodiment provides an electronic device 600, including: one or more processors 620; a storing apparatus 610, configured to store one or more programs, when the one or more programs are executed by the one or more processors 620, the one or more processors 620 implementing the turnout fault diagnosing method provided in the embodiment of the present application, the method including:
Acquiring the target turnout action curve of the target turnout; the turnout action curve including a series of discrete sequence items generated by turnout actions at different trigger times;
Segmenting the target turnout action curve according to the value of each discrete sequence item in the target turnout action curve; and
Performing fault diagnosis on the curve segments divided into each turnout action phase, according to the segmentation result of the target turnout action curve, so as to implement the fault diagnosis of the target turnout.

Of course, those skilled in the art can understand that the processor 620 further implements the technical solution of the turnout fault diagnosing method provided by any embodiment of the present application.

The electronic device 600 shown in FIG. 6 is only an example, and should not make any limitation to the functions and scope of use of the embodiments of the present application.

As shown in FIG. 6, the electronic device 600 includes a processor 620, a storing apparatus 610, an input apparatus 630, and an output apparatus 640; the number of processors 620 in the electronic device may be one or more, and in FIG. 6, one processor 620 is taken as an example; the processor 620, the storing apparatus 610, the input apparatus 630, and the output apparatus 640 in the electronic device may be connected by a bus or other means, and In FIG. 6, the connection with the bus 650 is taken as an example.

As a computer-readable storage medium, the storing apparatus 610 can be configured to store software programs, computer-executable programs, and module units, such as program instructions corresponding to the turnout fault diagnosing method in the embodiment of the present application.

The storing apparatus 610 may mainly include a storage program region and a storage data region, wherein the storage program region may store an operating system and an application program that is required by at least one function; the storage data region may store data that is created according to the use of a terminal, and the like. In addition, the storing apparatus 610 may include a high-speed random access memory, and may further include a non-volatile memory, such as at least one magnetic disk storage device, a flash memory device, or other non-volatile solid-state storage devices. In some examples, the storing apparatus 610 may further include memories remotely provided with respect to the processor 620, and these remote memories may be connected via a network. Examples of the above network include, but are not limited to, the Internet, Intranet, local area networks, mobile communication networks, and combinations thereof.

The input apparatus 630 may be used to receive inputted numbers, character information, or voice information, and generate key signal input related to user settings and function control of the electronic device. The output apparatus 640 may include electronic devices, such as a display screen, a loudspeaker, etc.

The electronic equipment provided by the embodiment of the present application can achieve the technical effect that the position of the turnout fault is located more accurately, which helps the device maintainer to quickly handle the fault, to shorten the influence time on the railway operation.

Embodiment five of the present invention provides a computer-readable medium having a computer program stored thereon, and when being executed by a processor, the program is used to perform a turnout fault diagnosing method, the method including:
Acquiring the target turnout action curve of the target turnout; the turnout action curve including a series of discrete sequence items generated by the turnout actions at different trigger times;
Segmenting the target turnout action curve according to the value of each discrete sequence item in the target turnout action curve; and
Performing fault diagnosis on the curve segments divided into each turnout action phase, according to the segmentation result of the target turnout action curve, so as to implement the fault diagnosis of the target turnout.

Optionally, when being executed by the processor, the program can further be used to execute the switch fault diagnosing method provided by any embodiment of the present invention.

The computer storage medium of the embodiment of the present invention may adopt any combination of one or more computer-readable mediums. The computer-readable medium may be a computer-readable signal medium or a computer-readable storage medium. The computer-readable storage medium may be, for example, but not limited to, an electrical, magnetic, optical, electromagnetic, infrared, or semi-conductive system, apparatus, or device, or any combination of the above. More specific examples (non-exhaustive list) of computer-readable storage mediums include: electrical connection with one or more wires, a portable computer disk, a hard disk, Random Access Memory (RAM), Read Only Memory (ROM), Erasable Programmable Read Only Memory (EPROM), a flash memory, an optical fiber, a portable CD-ROM, an optical storage device, a magnetic storage device, or any suitable combination of the foregoing. The computer-readable storage medium may be any tangible medium that contains or stores a program, and the program may be used by or in combination with an instruction execution system, apparatus, or device.

The computer-readable signal medium may include a data signal propagated in baseband or as a part of a carrier, and a computer-readable program code is carried therein. This propagated data signal can take many forms, including but not limited to: electromagnetic signals, optical signals, or any suitable combination thereof. The computer-readable signal medium may also be any computer-readable medium other than a computer-readable storage medium, and the computer-readable medium may send, propagate, or transmit the program for use by or in combination with the instruction execution system, apparatus, or device.

A program code contained on the computer readable medium can be transmitted by any suitable medium, including but not limited to: wireless, wire, optical cable, Radio Frequency (RF), etc., or any suitable combination thereof.

The computer program code used to perform the operations of the present invention can be written in one or more programming languages or a combination thereof, the programming languages include object-oriented programming languages, such as Java, Smalltalk, C++, and further including conventional procedural programming languages, such as "C" language or similar programming language. The program code can be executed completely on the user's computer, partly on the user's computer, as a stand-alone software package, partly on the user's computer and partly on a remote computer, or completely on a remote computer or a server. In the scenario with the remote computer, the remote computer may be connected to the user's computer through any type of network, including Local Area Network (LAN) or Wide Area Network (WAN), or connected to an external computer (for example, through the Internet connection from an Internet Service Provider).

In the description of this specification, descriptions with reference to the terms "one embodiment", "some embodiments", "examples", "specific examples", or "some examples" etc. mean that the specific features, structures, materials or characteristics described in conjunction with the embodiments or examples are included in at least one embodiment or example of the present invention. In this specification, the schematic representations of the above-mentioned terms do not necessarily refer to the same embodiment or example.

It should be noted that the above are only the preferred embodiments of the present invention. Those skilled in the art will understand that the present invention is not limited to the specific embodiments described herein, and various obvious changes, readjustments and substitutions can be made to those skilled in the art without departing from the protection scope of the present invention. Therefore, although the present invention has been described in more detail through the above embodiments, the present invention is not limited to the above embodiments, and can also include more other embodiments without departing from the scope of the present invention, and the scope of the present invention is determined by the scope of the appended claims.

## Claims

1. A method for diagnosing a turnout fault, comprising:
(S110) 8110; acquiring a target turnout action curve of a target turnout; the turnout action curve comprising a series of discrete sequence items generated by turnout actions at different trigger times;
(S120) segmenting the target turnout action curve into curve segments, according to values of the discrete sequence items in the target turnout action curve; and
(S130) according to the segmented result of the target turnout action curve, performing fault diagnosis on the curve segment in each turnout action phase, so as to implement the fault diagnosis for the target turnout, including
at a turnout unlocking phase and a turnout switch phase, if values of the discrete sequence items in curve segments at the turnout unlocking phase and the turnout switch phase in the target turnout action curve are continuously greater than a turnout unlocking threshold value for a preset time period, determining that the target turnout has a turnout unlocked fault;
at a turnout switch phase, if values of the discrete sequence items in curve segments at the turnout switch phase in the target turnout action curve are continuously less than a turnout idling threshold value for a preset period of time, determining that the target turnout has a turnout idling fault;
at a turnout switch phase, if the target turnout action curve is greater than a turnout jam threshold value, determining that the target turnout has a turnout jam fault;
at a turnout lock phase, if values of the discrete sequence items in curve segments at the turnout locking phase of the target turnout action curve are all greater than zero, determining that the target turnout has a turnout unlocking fault.

2. The method according to claim 1, wherein a type of the discrete sequence items is power or current.

3. The method according to claim 1, wherein segmenting the target turnout action curve according to the values of the discrete sequence items in the target turnout action curve comprises:
taking a discrete sequence item with a maximum value in the discrete sequence items in the turnout action curve as a start point of a turnout unlocking phase in the target turnout action curve.

4. The method according to claim 1, wherein segmenting the target turnout action curve, according to the values of the discrete sequence items in the target turnout action curve, comprises:
(S220) determining target discrete sequence items from all the discrete sequence items, according to the values of the discrete sequence items in the target turnout action curve, including
for each discrete sequence item in the target turnout action curve, determining some other discrete sequence items, between which and the each discrete sequence item a value difference is within a preset difference range, from all the discrete sequence items in the target turnout action curve;
taking the ratio of the number of the some other discrete sequence items to the total number of the discrete sequence items in the target turnout action curve as the aggregation density of the each discrete sequence item; and
taking discrete sequence items whose aggregation density is greater than the preset density threshold value in the discrete sequence items of the target turnout action curve as the target discrete sequence items;
and
(S230) determining a start point and an end point corresponding to a turnout rotation phase in the target turnout action curve, according to the trigger times corresponding to the target discrete sequence items.

5. The method according to claim 4, wherein determining the start point and the end point corresponding to the turnout rotation phase of the target turnout action curve, according to the trigger times corresponding to the target discrete sequence items, comprises:
sorting adjacent target discrete sequence items, according to the sequence of the trigger times corresponding to the target discrete sequence items;
taking the first target discrete sequence and the last target discrete sequence item from a sorting result as the start point and the end point of the turnout rotation phase in the target turnout action curve, respectively.

6. An apparatus for diagnosing a turnout fault, which is configured to perform the method of claims 1 to 5, comprising:
a curve acquisition module (510), configured to acquire the target turnout action curve of the target turnout; the turnout action curve comprising a series of discrete sequence items generated by the turnout actions at different trigger times;
a curve segmentation module (520), configured to segment the target turnout action curve, according to the value of each discrete sequence item in the target turnout action curve; and
a fault diagnosis module (530), configured to perform the fault diagnosis on the curve segment in each turnout action phase, according to the segmented result of the target turnout action curve, so as to implement the fault diagnosis of the target turnout.

7. An electronic device (600), comprising:
one or more processors (620);
a storing apparatus (610), configured to store one or more programs having instructions;
wherein, when the one or more programs are executed by the one or more processors, said instructions cause the one or more processors to carry out the method for diagnosing a turnout fault according to any one of claims 1-5.

8. A computer-readable storage medium having a computer program stored thereon, wherein the program comprises instructions which, when the program is executed by a processor, causes the processor to carry out the method for diagnosing a turnout fault according to any one of claims 1-5.

## Patentansprüche

1. Verfahren zum Diagnostizieren eines Weichenfehlers, Folgendes umfassend:
(S110) Erfassen einer Ziel-Weichenaktionskurve einer Ziel-Weiche; wobei die Weichenaktionskurve eine Reihe von diskreten Sequenzelementen umfasst, die durch Weichenaktionen zu verschiedenen Auslösezeiten erzeugt werden;
(S120) Segmentieren der Ziel-Weichenaktionskurve in Kurvensegmente, gemäß den Werten der diskreten Sequenzelemente in der Ziel-Weichenaktionskurve; und
(S130) gemäß dem segmentierten Ergebnis der Ziel-Weichenaktionskurve, Durchführen einer Fehlerdiagnose an dem Kurvensegment in jeder Weichenaktionsphase, sodass die Fehlerdiagnose für die Ziel-Weiche implementiert wird, beinhaltend
in einer Weichenentriegelungsphase und einer Weichenumschaltphase, wenn Werte der diskreten Sequenzelemente in Kurvensegmenten in der Weichenentriegelungsphase und der Weichenumschaltphase in der Ziel-Weichenaktionskurve kontinuierlich größer als ein Weichenentriegelungsschwellenwert für eine voreingestellte Zeitperiode sind, Bestimmen, dass die Ziel-Weiche einen Weichenentriegelungsfehler aufweist;
in einer Weichenumschaltphase, wenn Werte der diskreten Sequenzelemente in Kurvensegmenten in der Weichenumschaltphase in der Ziel-Weichenaktionskurve kontinuierlich weniger als ein Weichenleerlaufschwellenwert für eine voreingestellte Zeitperiode sind, Bestimmen, dass die Ziel-Weiche einen Weichenleerlauffehler aufweist;
in einer Weichenumschaltphase, wenn die Ziel-Weichenaktionskurve größer als ein Weichenstauschwellenwert ist, Bestimmen, dass die Ziel-Weiche einen Weichenstaufehler aufweist;
in einer Weichenverriegelungsphase, wenn Werte der diskreten Sequenzelemente in Kurvensegmenten in der Weichenverriegelungsphase der Ziel-Weichenaktionskurve alle größer als Null sind, Bestimmen, dass die Ziel-Weiche einen Weichenentriegelungsfehler aufweist.

2. Verfahren nach Anspruch 1, wobei ein Typ der diskreten Sequenzelemente Energie oder Strom ist.

3. Verfahren nach Anspruch 1, wobei das Segmentieren der Ziel-Weichenaktionskurve gemäß den Werten der diskreten Sequenzelemente in der Ziel-Weichenaktionskurve Folgendes umfasst:
Nehmen eines diskreten Sequenzelements mit einem Maximalwert in den diskreten Sequenzelementen in der Weichenaktionskurve als Startpunkt einer Weichenentriegelungsphase in der Ziel-Weichenaktionskurve.

4. Verfahren nach Anspruch 1, wobei das Segmentieren der Ziel-Weichenaktionskurve gemäß den Werten der diskreten Sequenzelemente in der Ziel-Weichenaktionskurve Folgendes umfasst:
(S220) Bestimmen von diskreten Ziel-Sequenzelementen aus allen diskreten Sequenzelementen, gemäß den Werten der diskreten Sequenzelemente in der Ziel-Weichenaktionskurve, beinhaltend für jedes diskrete Sequenzelement in der Ziel-Weichenaktionskurve, Bestimmen einiger anderer diskreter Sequenzelemente, zwischen denen und dem jeweiligen diskreten Sequenzelement eine Wertedifferenz innerhalb eines voreingestellten Differenzbereichs liegt, von allen diskreten Sequenzelementen in der Ziel-Weichenaktionskurve;
Nehmen des Verhältnisses der Anzahl der einigen anderen diskreten Sequenzelemente zu der Gesamtanzahl der diskreten Sequenzelemente in der Ziel-Weichenaktionskurve als die Aggregationsdichte der jeweiligen diskreten Sequenzelemente; und
Nehmen diskreter Sequenzelemente, deren Aggregationsdichte in den diskreten Sequenzelementen der Ziel-Weichenaktionskurve größer als der voreingestellte Dichteschwellenwert ist, als die diskreten Ziel-Sequenzelemente; und
(S230) Bestimmen eines Startpunktes und eines Endpunktes, die einer Weichenrotationsphase in der Ziel-Weichenaktionskurve entsprechen, gemäß den Auslösezeiten, die den diskreten Ziel-Sequenzelementen entsprechen.

5. Verfahren nach Anspruch 4, wobei das Bestimmen des Startpunktes und des Endpunktes, die der Weichenrotationsphase der Ziel-Weichenaktionskurve entsprechen, gemäß den Auslösezeiten, die den diskreten Ziel-Sequenzelementen entsprechen, Folgendes umfasst:
Sortieren benachbarter diskreter Ziel-Sequenzelemente, gemäß der Sequenz der Auslösezeiten, die den diskreten Ziel-Sequenzelementen entspricht;
Nehmen der ersten diskreten Ziel-Sequenz und des letzten diskreten Ziel-Sequenzelements aus einem Sortierergebnis als den Startpunkt beziehungsweise den Endpunkt der Weichenrotationsphase in der Ziel-Weichenaktionskurve.

6. Gerät zum Diagnostizieren eines Weichenfehlers, das so konfiguriert ist, dass es das Verfahren der Ansprüche 1 bis 5 durchführt, Folgendes umfassend:
ein Kurvenerfassungsmodul (510), das so konfiguriert ist, dass es die Ziel-Weichenaktionskurve der Ziel-Weiche erfasst; wobei die Weichenaktionskurve eine Reihe von diskreten Sequenzelementen umfasst, die durch die Weichenaktionen zu verschiedenen Auslösezeiten erzeugt werden;
ein Kurvensegmentierungsmodul (520), das so konfiguriert ist, dass es die Ziel-Weichenaktionskurve gemäß dem Wert jedes diskreten Sequenzelements in der Ziel-Weichenaktionskurve segmentiert; und
ein Fehlerdiagnosemodul (530), das so konfiguriert ist, dass es die Fehlerdiagnose an dem Kurvensegment in jeder Weichenaktionsphase gemäß dem segmentierten Ergebnis der Ziel-Weichenaktionskurve durchführt, sodass die Fehlerdiagnose für die Ziel-Weiche implementiert wird.

7. Elektronische Vorrichtung (600), Folgendes umfassend:
einen oder mehrere Prozessoren (620);
ein Speichergerät (610), das so konfiguriert ist, dass es ein oder mehrere Programme speichert, die Anweisungen aufweisen;
wobei, wenn das eine oder die mehreren Programme durch den einen oder die mehreren Prozessoren ausgeführt werden, die Anweisungen den einen oder die mehreren Prozessoren veranlassen, das Verfahren zum Diagnostizieren eines Weichenfehlers gemäß einem der Ansprüche 1-5 durchzuführen.

8. Computerlesbares Speichermedium, das ein darauf gespeichertes Computerprogramm aufweist, wobei das Programm Anweisungen umfasst, die, wenn das Programm durch einen Prozessor ausgeführt wird, den Prozessor veranlassen, das Verfahren zum Diagnostizieren eines Weichenfehlers nach einem der Ansprüche 1-5 durchzuführen.

## Revendications

1. Procédé de diagnostic d'un défaut d'aiguillage, comprenant :
(S110) l'acquisition d'une courbe d'action d'aiguillage cible d'un aiguillage cible ; la courbe d'action d'aiguillage comprenant une série d'éléments de séquence discrets générés par des actions d'aiguillage à différents moments de déclenchement ;
(S120) la segmentation de la courbe d'action d'aiguillage cible en segments de courbe, selon les valeurs des éléments de séquence discrets dans la courbe d'action d'aiguillage cible ; et
(S130) en fonction du résultat segmenté de la courbe d'action d'aiguillage cible, la réalisation d'un diagnostic de défaut sur le segment de courbe dans chaque phase d'action d'aiguillage, de manière à mettre en œuvre le diagnostic de défaut pour l'aiguillage cible, comprenant
lors d'une phase de déverrouillage d'aiguillage et d'une phase de commutation d'aiguillage, si les valeurs des éléments de séquence discrets dans les segments de courbe lors de la phase de déverrouillage d'aiguillage et de la phase de commutation d'aiguillage dans la courbe d'action d'aiguillage cible sont continuellement supérieures à une valeur seuil de déverrouillage d'aiguillage pendant une période prédéfinie, la détermination que l'aiguillage cible présente un défaut de déverrouillage d'aiguillage ;
lors d'une phase de commutation d'aiguillage, si les valeurs des éléments de séquence discrets dans les segments de courbe lors de la phase de commutation d'aiguillage dans la courbe d'action d'aiguillage cible sont continuellement inférieures à une valeur seuil de ralenti d'aiguillage pendant une période prédéfinie, la détermination que l'aiguillage cible présente un défaut de ralenti d'aiguillage ;
lors d'une phase de commutation d'aiguillage, si la courbe d'action d'aiguillage cible est supérieure à une valeur seuil de blocage d'aiguillage, la détermination que l'aiguillage cible présente un défaut de blocage d'aiguillage ;
lors d'une phase de verrouillage d'aiguillage, si les valeurs des éléments de séquence discrets dans les segments de courbe lors de la phase de verrouillage d'aiguillage de la courbe d'action d'aiguillage cible sont toutes supérieures à zéro, la détermination que l'aiguillage cible présente un défaut de déverrouillage d'aiguillage.

2. Procédé selon la revendication 1, dans lequel un type des éléments de séquence discrets est la puissance ou le courant.

3. Procédé selon la revendication 1, dans lequel la segmentation de la courbe d'action d'aiguillage cible en fonction des valeurs des éléments de séquence discrets dans la courbe d'action d'aiguillage cible comprend :
la prise d'un élément de séquence discret avec une valeur maximale dans les éléments de séquence discrets dans la courbe d'action d'aiguillage comme point de départ d'une phase de déverrouillage d'aiguillage dans la courbe d'action d'aiguillage cible.

4. Procédé selon la revendication 1, dans lequel la segmentation de la courbe d'action d'aiguillage cible, en fonction des valeurs des éléments de séquence discrets dans la courbe d'action d'aiguillage cible, comprend ;
(S220) la détermination d'éléments de séquence discrets cibles parmi tous les éléments de séquence discrets, en fonction des valeurs des éléments de séquence discrets dans la courbe d'action d'aiguillage cible, comprenant
pour chaque élément de séquence discret dans la courbe d'action d'aiguillage cible, la détermination de certains autres éléments de séquence discrets, entre lesquels et chaque élément de séquence discret, une différence de valeur se situe dans une plage de différence prédéfinie, parmi tous les éléments de séquence discrets dans la courbe d'action d'aiguillage cible ; la prise du rapport entre le nombre des certains autres éléments de séquence discrets et le nombre total des éléments de séquence discrets dans la courbe d'action d'aiguillage cible comme densité d'agrégation de chaque élément de séquence discrète ; et
la prise comme éléments de séquence discrets dont la densité d'agrégation est supérieure à la valeur seuil de densité prédéfinie dans les éléments de séquence discrets de la courbe d'action d'aiguillage cible comme éléments de séquence discrets cibles ; et
(S230) la détermination d'un point de départ et un point d'arrivée correspondant à une phase de rotation d'aiguillage dans la courbe d'action d'aiguillage cible, en fonction des temps de déclenchement correspondant aux éléments de séquence discrets cibles.

5. Procédé selon la revendication 4, dans lequel la détermination du point de départ et du point d'arrivée correspondant à la phase de rotation d'aiguillage de la courbe d'action d'aiguillage cible, en fonction des temps de déclenchement correspondant aux éléments de séquence discrets cibles, comprend :
le tri d'éléments de séquence discrets cibles adjacents, en fonction de la séquence des temps de déclenchement correspondant aux éléments de séquence discrets cibles ;
la prise du premier élément de séquence discret cible et du dernier élément de séquence discret cible parmi un résultat de tri comme point de départ et point d'arrivée de la phase de rotation d'aiguillage dans la courbe d'action d'aiguillage cible, respectivement.

6. Appareil de diagnostic d'un défaut d'aiguillage, qui est configuré pour mettre en œuvre le procédé selon les revendications 1 à 5, comprenant :
un module d'acquisition de courbe (510), configuré pour acquérir la courbe d'action d'aiguillage cible de l'aiguillage cible ; la courbe d'action d'aiguillage comprenant une série d'éléments de séquence discrets générés par les actions d'aiguillage à différents moments de déclenchement ;
un module de segmentation de courbe (520), configuré pour segmenter la courbe d'action d'aiguillage cible, en fonction de la valeur de chaque élément de séquence discret dans la courbe d'action d'aiguillage cible ; et
un module de diagnostic de défaut (530), configuré pour effectuer le diagnostic de défaut sur le segment de courbe dans chaque phase d'action d'aiguillage, en fonction du résultat segmenté de la courbe d'action d'aiguillage cible, de manière à mettre en œuvre le diagnostic de défaut de l'aiguillage cible.

7. Dispositif électronique (600) comprenant :
un ou plusieurs processeurs (620) ;
un appareil de stockage (610), configuré pour stocker un ou plusieurs programmes contenant des instructions ;
dans lequel, lorsque l'un ou les plusieurs programmes sont exécutés par l'un ou les plusieurs processeurs, lesdites instructions amènent l'un ou les plusieurs processeurs à exécuter le procédé de diagnostic d'un défaut d'aiguillage selon l'une quelconque des revendications 1 à 5.

8. Support de stockage lisible par ordinateur sur lequel est stocké un programme informatique, dans lequel le programme comprend des instructions qui, lorsque le programme est exécuté par un processeur, amènent le processeur à exécuter le procédé de diagnostic d'un défaut d'aiguillage selon l'une quelconque des revendications 1 à 5.
